# EUROPEAN PATENT APPLICATION

(11) **EP 4 659 988 A1**
(43) Date of publication of application: **10.12.2025**
(21) Application number: 23926767.7
(22) Date of filing: 15.03.2023
(51) Int. Cl.: B60L 3/00, B60L 58/24

(54) **BATTERY MANAGEMENT SYSTEM, ELECTRIC VEHICLE AND POWER BATTERY PROTECTION METHOD**

(71) Applicant: ZHEJIANG ZEEKR INTELLIGENT TECHNOLOGY CO., LTD., Ningbo, Zhejiang 315899 (CN); VIRIDI E-MOBILITY TECHNOLOGY (NINGBO) CO., LTD., Ningbo, Zhejiang 315336 (CN); Zhejiang Geely Holding Group Co., Ltd., Hangzhou, Zhejiang 310051 (CN)
(72) Inventor: HE, Yangfan, Ningbo, Zhejiang 315899 (CN); CHEN, Deting, Ningbo, Zhejiang 315899 (CN); LIU, Gang, Ningbo, Zhejiang 315899 (CN); CHEN, Xiao, Ningbo, Zhejiang 315899 (CN); ZHAO, Lei, Ningbo, Zhejiang 315899 (CN); SHEN, Yanliang, Ningbo, Zhejiang 315899 (CN); LIU, Wei, Ningbo, Zhejiang 315899 (CN); HE, Xin, Ningbo, Zhejiang 315899 (CN); CAO, Jigang, Ningbo, Zhejiang 315899 (CN); NIU, Yaqi, Ningbo, Zhejiang 315899 (CN)
(74) Representative: Michalski Hüttermann & Partner Patentanwälte mbB
(86) International application number: PCT/CN2023/081631
(87) International publication number: WO 2024/187410

(57) **Abstract**

A battery management system, an electric vehicle, and a power battery protection method. The battery management system (10) includes a detection board and a control board (13). The detection board is connected to a vehicle-mounted power battery (20), and is configured for detecting a cell thermal runaway state of the power battery (20). The control board (13) is connected to the detection board, and includes a power supply chip (131) and a controller (132). The detection board is disposed independently of the control board (13), the detection board is connected to the power supply chip (131), and the power supply chip (131) is connected to the controller (132). The power battery protection method includes: detecting a cell thermal runaway state of the vehicle-mounted power battery (20); when the battery management system (10) is offline, generating a wake-up signal in response to detecting that thermal runaway occurs in a cell of the power battery (20); and waking up the battery management system (10) to operate via the wake-up signal and issuing a thermal runaway alarm, which can provide good safety protection for the power battery (20).

## Description

### TECHNICAL FIELD

Embodiments of the present disclosure relate to the field of electric vehicle technologies, and in particular to a battery management system, an electric vehicle, and a power battery protection method.

### BACKGROUND

With the continuous consumption of oil and gas energy and the continuous enhancement of environmental protection awareness, electric vehicles are being actively promoted and used as a new environmentally-friendly vehicle alternative to the original traditional energy vehicles. Power battery is an important power source for electric vehicles, and the safety of the power battery is the first issue to be considered and solved during the development of the electric vehicles. Generally, a power battery in an electric vehicle includes a plurality of battery cells connected in series and/or parallel to form a battery pack. Due to the high energy of the battery pack, thermal runaway of the power battery and burning of a battery cell in the power battery can easily occur under special conditions such as short circuit or collision. A large amount of heat may be released along with the burning of the cell, and if not handled in time or handled improperly, the entire battery system may be caused to catch fire and burn, or even explode, leading to loss of life and property.

In recent years, spontaneous combustion problems in electric vehicles have emerged frequently. In view of this, if the use of new energy electric vehicles is to be promoted on a large scale, the safety of power batteries needs to be improved. Therefore, how to avoid or reduce the occurrence of thermal runaway of the batteries has become a major challenge currently encountered in the field of electric vehicles.

### SUMMARY

Embodiments of the present disclosure provide a battery management system, an electric vehicle, and a power battery protection method, which can well protect a power battery.

According to an aspect of the embodiments of the present disclosure, a battery management system is provided. The battery management system includes a detection board and a control board. The detection board is connected to a vehicle-mounted power battery, and is configured for detecting a cell thermal runaway state of the power battery. The control board is connected to the detection board, and the control board includes a power supply chip and a controller, where the detection board is disposed independently of the control board, the detection board is connected to the power supply chip, and the power supply chip is connected to the controller.

In an optional embodiment, when the battery management system is offline, in response to detecting that thermal runaway occurs in a cell of the power battery, the detection board is further configured for generating a wake-up signal, and waking up the controller via the power supply chip to enable the battery management system to operate.

In an optional embodiment, when the thermal runaway occurs in the cell of the power battery, the controller is further configured for issuing a thermal runaway alarm.

In an optional embodiment, the detection board includes a cell collection board, and the cell collection board is configured for collecting a cell voltage and/or a cell temperature of the power battery online and/or offline at a predetermined sampling period.

In an optional embodiment, the cell collection board is configured for: comparing the collected cell voltage of the power battery with a predetermined voltage limit and/or comparing the collected cell temperature of the power battery with a predetermined temperature limit, and generating the wake-up signal in response to the cell voltage of the power battery exceeding the predetermined voltage limit and/or the cell temperature of the power battery exceeding the predetermined temperature limit.

In an optional embodiment, the detection board further includes a high-voltage current collection board, and the high-voltage current collection board is configured for collecting a current of the power battery.

In an optional embodiment, the high-voltage current collection board is configured for obtaining the current of the power battery by collecting a voltage across a detection resistor connected in series in a load circuit, where the load circuit includes the power battery and a load connected in series.

In an optional embodiment, in response to the collected current of the power battery exceeding an overcurrent protection current limit, the high-voltage current collection board is further configured for generating an overcurrent hardware signal to the controller, such that the controller is configured for performing overcurrent protection on the power battery.

In an optional embodiment, in response to the collected current of the power battery exceeding a short-circuit protection current limit, the high-voltage current collection board is further configured for generating a short-circuit hardware signal to the controller, such that the controller is configured for controlling a pyrofuse connected in series in a load circuit to blow.

In an optional embodiment, the control board further includes a low-voltage uninterruptible power supply and a pressure detection module, the low-voltage uninterruptible power supply is configured for supplying power to the pressure detection module, the pressure detection module is connected to the power supply chip, and the pressure detection module is configured for detecting a pressure of the power battery online and/or offline.

In an optional embodiment, when the battery management system is offline, in response to the detected pressure of the power battery exceeding a predetermined pressure limit, the pressure detection module is further configured for generating a wake-up signal, and waking up the controller via the power supply chip to enable the battery management system to operate.

According to another aspect of the embodiments of the present disclosure, an electric vehicle is provided. The electric vehicle includes the battery management system according to any one of the foregoing embodiments.

According to still another aspect of the embodiments of the present disclosure, a power battery protection method is provided. The method includes: detecting a cell thermal runaway state of a vehicle-mounted power battery; generating a wake-up signal in response to detecting that thermal runaway occurs in a cell of the power battery when a battery management system is offline; and waking up the battery management system to operate via the wake-up signal and issuing a thermal runaway alarm.

In an optional embodiment, detecting the cell thermal runaway state of the vehicle-mounted power battery includes: collecting a cell voltage and/or a cell temperature of the power battery online and/or offline at a predetermined sampling period; comparing the collected cell voltage of the power battery with a predetermined voltage limit and/or comparing the collected cell temperature of the power battery with a predetermined temperature limit; and determining that the thermal runaway occurs in the cell of the power battery in response to the cell voltage of the power battery exceeding the predetermined voltage limit and/or the cell temperature of the power battery exceeding the predetermined temperature limit.

In an optional embodiment, detecting the cell thermal runaway state of the vehicle-mounted power battery includes: collecting a current of the power battery; and determining that the thermal runaway occurs in the cell of the power battery in response to the collected current of the power battery exceeding a short-circuit protection current limit.

In an optional embodiment, the method further includes: in response to the collected current of the power battery exceeding an overcurrent protection current limit, generating an overcurrent hardware signal to the battery management system to perform overcurrent protection on the power battery; and in response to the collected current of the power battery exceeding a short-circuit protection current limit, generating a short-circuit hardware signal to the battery management system, such that the battery management system controls a pyrofuse connected in series in a load circuit to blow, where the load circuit includes the power battery and a load connected in series.

In an optional embodiment, detecting the cell thermal runaway state of the vehicle-mounted power battery includes: detecting a pressure of the power battery online and/or offline; comparing the detected pressure of the power battery with a predetermined pressure limit; and determining that the thermal runaway occurs in the cell of the power battery in response to the pressure of the power battery exceeding the predetermined pressure limit.

The battery management system, the electric vehicle, and the power battery protection method according to one or more embodiments of the present disclosure can provide good protection for the power battery.

### BRIEF DESCRIPTION OF DRAWINGS

In order to more clearly illustrate the technical solutions in embodiments of the present disclosure, the accompanying drawings to be used in description of the embodiments will be briefly described below. Apparently, the drawings in the following description are merely some of the embodiments of the present disclosure, and a person of ordinary skill in the art may obtain other drawings from these drawings without creative efforts.
FIG. 1 is a schematic block diagram of a battery management system according to an embodiment of the present disclosure.
FIG. 2 is a block diagram of a portion of an internal structure of a control board according to an embodiment of the present disclosure.
FIG. 3 is a flowchart of a power battery protection method according to an embodiment of the present disclosure.
FIG. 4 illustrates specific steps of a power battery protection method according to an embodiment of the present disclosure.

### DETAILED DESCRIPTION

The technical solutions in the embodiments of the present disclosure will be described clearly and completely below with reference to the accompanying drawings in the embodiments of the present disclosure. Apparently, the embodiments described are merely a part of the embodiments of the present disclosure, rather than all of the embodiments. All other embodiments obtained by a person of ordinary skill in the art based on the embodiments of the present disclosure without creative efforts shall fall within the scope of protection of the present disclosure.

Reference will now be made in detail to exemplary embodiments, examples of which are illustrated in the accompanying drawings. When the following description refers to the drawings, the same reference numerals in different drawings indicate the same or similar elements, unless otherwise specified. The implementations set forth in the following description of exemplary embodiments do not represent all implementations consistent with the present disclosure. Instead, they are merely examples of apparatuses and methods consistent with some aspects of the present disclosure as detailed in the appended claims.

The terminology used herein is for the purpose of describing particular embodiments only and is not intended to be limiting of the present disclosure. The singular forms "a", "said" and "the" used in the present disclosure and the appended claims are intended to include plural forms as well, unless the context clearly indicates otherwise. It should also be understood that the term "and/or" as used herein refers to and encompasses any or all possible combinations of one or more of the associated listed items. Unless otherwise specified, words such as "front", "rear", "lower", and/or "upper" and the like are merely for ease of description, and are not limited to one position or one spatial orientation. The terms "connected", "coupled" and the like are not limited to physical or mechanical connections, and may include electrical connections, whether direct or indirect. In the present disclosure, "capable of" may indicate having the capability.

Various embodiments of the present disclosure will be described in detail below with reference to the accompanying drawings. Features in the following embodiments and implementations may be combined with each other without conflict.

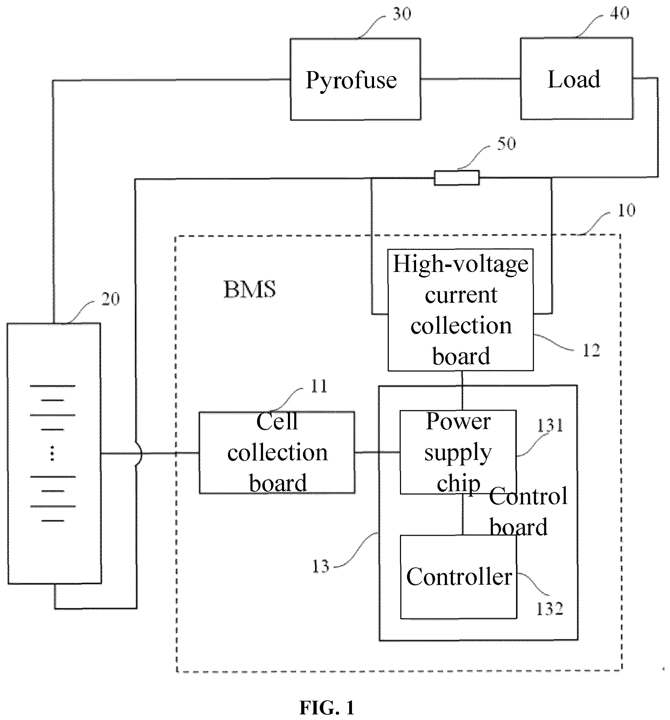

An embodiment of the present disclosure provides a battery management system (BMS) 10. FIG. 1 illustrates a schematic block diagram of the battery management system 10 according to the embodiment of the present disclosure. As shown in FIG. 1, the battery management system 10 according to the embodiment of the present disclosure includes a detection board and a control board 13, where the detection board is disposed independently of the control board 13. The detection board is connected to a vehicle-mounted power battery 20, and is configured to detect a cell thermal runaway state of the power battery 20. The control board 13 is connected to the detection board. The control board 13 includes a power supply chip 131 and a controller 132. The power supply chip 131 is configured to supply power to the entire BMS. The power supply chip 131 is connected to the controller 132. The detection board is connected to the power supply chip 131 in the control board 13.

The detection board is configured to detect the cell thermal runaway state of the power battery 20. When the battery management system 10 is offline, in response to detecting that thermal runaway occurs in a cell of the power battery 20, the detection board may generate a wake-up signal and send the wake-up signal to the control board 13. The power supply chip 131 of the control board 13 is powered on and started, and the controller 132 may be woken up via the power supply chip 131. In this way, the BMS 10 operates, and then the entire vehicle is woken up.

In some embodiments, when the thermal runaway occurs in the cell of the power battery 20, the controller 132 in the BMS may further issue a thermal runaway alarm, so as to provide an early warning alert to the driver and passengers.

In some embodiments, the detection board according to the present disclosure may include a cell collection board 11. The cell collection board 11 is disposed independently of the control board 13. The cell collection board 11 is connected to the power battery 20, and the cell collection board 11 is connected to the power supply chip 131 of the control board 13. The cell collection board 11 may collect a cell voltage and/or a cell temperature of the power battery 20 online and/or offline at a predetermined sampling period.

The cell collection board 11 may compare the collected cell voltage of the power battery 20 with a predetermined voltage limit and/or compare the collected cell temperature of the power battery 20 with a predetermined temperature limit, and when the battery management system 10 is offline, in response to the cell voltage of the power battery 20 exceeding the predetermined voltage limit and/or the cell temperature of the power battery 20 exceeding the predetermined temperature limit, generate a wake-up signal. For example, the cell collection board 11 may continuously detect the cell voltage and/or cell temperature of the power battery 20 when the entire vehicle enters a sleep state. When the cell voltage of the power battery 20 exceeds a predetermined upper voltage limit or a predetermined lower voltage limit, and/or the cell temperature of the power battery 20 exceeds a predetermined upper temperature limit or a predetermined lower temperature limit, the cell collection board 11 may generate the wake-up signal, such that the power supply chip 131 on the control board 13 is powered on and starts to wake up the controller 132 on the control board 13. In this way, the entire BMS 10 operates, thereby waking up the entire vehicle and issuing the thermal runaway alarm.

The battery management system 10 according to the embodiment of the present disclosure can support not only online detection of battery thermal runaway, but also offline detection of the thermal runaway, and furthermore, can support immediate issuance of a thermal runaway alarm in offline detection of the thermal runaway.

In some embodiments, the detection board according to the present disclosure may further include a high-voltage current collection board 12. The high-voltage current collection board 12 is disposed independently of the control board 13, and the high-voltage current collection board 12 may be configured to collect a current of the power battery 20.

As shown in FIG. 1, the power battery 20 may be configured to power a load 40. The power battery 20 and the load 40 are connected in series to form a load circuit. A detection resistor 50 is connected in series in the load circuit. In an embodiment, the high-voltage current collection board 12 may be configured to collect a voltage across the detection resistor 50 connected in series in the load circuit to obtain the current of the power battery 20.

In some embodiments, the battery management system 10 according to the embodiment of the present disclosure may perform overcurrent protection. When the collected current of the power battery 20 exceeds an overcurrent protection current limit, the high-voltage current collection board 12 may generate an overcurrent hardware signal to the controller 132, such that the controller 132 may perform overcurrent protection on the power battery 20.

A pyrofuse (also referred to as "pyrotechnic fuse") 30 is also connected in series in the load circuit. Different from a conventional fuse, the pyrofuse 30 can be actively controlled, and the pyrofuse 30 is low-cost. Therefore, the use of such a pyrofuse can significantly reduce the cost and improve the competitive advantage. In some other embodiments, the battery management system 10 according to the embodiment of the present disclosure may further perform short-circuit protection. When the collected current of the power battery 20 exceeds a short-circuit protection current limit, the high-voltage current collection board 12 may generate a short-circuit hardware signal to the controller 132, such that the controller 132 may control the pyrofuse 30 connected in series in the load circuit to blow quickly, and disconnect the pyrofuse 30, thereby cutting off the high-voltage power supply of the entire vehicle and providing a good short-circuit protection for the power battery 20.

The battery management system 10 according to the embodiment of the present disclosure supports not only overcurrent protection, but also short-circuit protection. Moreover, the battery management system 10 can complete a short-circuit protection function in a relatively short time (e.g., 5 ms), to cut off the high-voltage power supply of the entire vehicle, and protect the power battery 20.

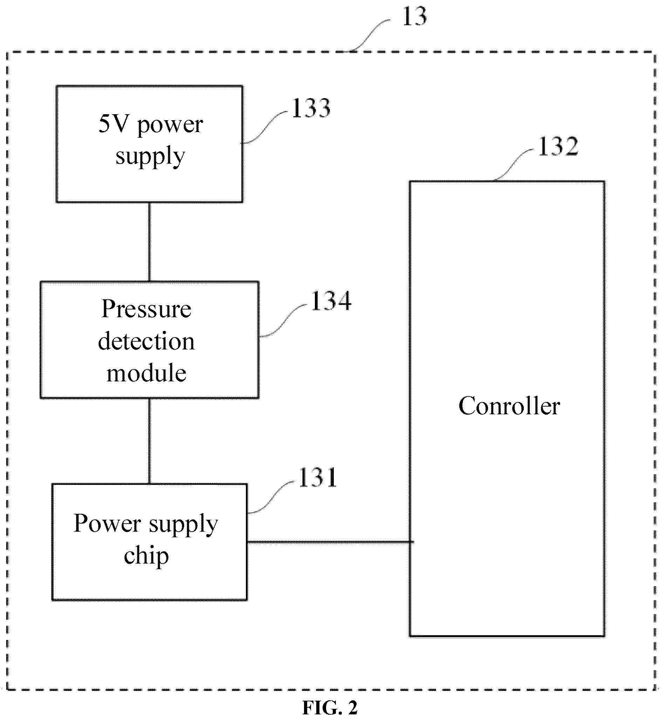

FIG. 2 illustrates a block diagram of a portion of an internal structure of the control board 13 according to an embodiment of the present disclosure. As shown in FIG. 2, in some embodiments, the control board 13 according to the present disclosure may further include a low-voltage uninterruptible power supply (LV-UPS) 133 and a pressure detection module 134. The low-voltage uninterruptible power supply 133 may be, for example, a 5V uninterruptible power supply. The low-voltage uninterruptible power supply 133 may be configured to supply power to the pressure detection module 134, and the pressure detection module 134 may detect a pressure of the power battery 20 online and/or offline. The pressure detection module 134 is connected to the power supply chip 131.

The pressure detection module 134 according to the embodiment of the present disclosure may continuously detect the pressure of the power battery 20 even when the entire vehicle enters the sleep state.

The pressure detection module 134 may compare the detected pressure of the power battery 20 with a predetermined pressure limit. When the pressure of the power battery 20 detected by the pressure detection module 134 exceeds the predetermined pressure limit and the battery management system 10 is offline, the pressure detection module 134 may generate the wake-up signal, such that the power supply chip 131 is powered on and started to wake up the controller 132. In this way, the entire BMS 10 operates, thereby waking up the entire vehicle and issuing a thermal runaway alarm.

The battery management system 10 according to the embodiment of the present disclosure integrates the pressure detection module 134 into the control board 13, and continuously supplies power to the pressure detection module 134 by using the low-voltage uninterruptible power supply 133, such that the pressure of the power battery 20 can be detected in real time, for example, at a fastest possible detection period of 10 ms. Moreover, the battery management system 10 can support online and/or offline detection of pressure, as well as an offline self-wake-up function.

The battery management system 10 according to the embodiment of the present disclosure can perform comprehensive safety management and efficient detection on the power battery 20, and can implement detection in full-condition scenarios, with high integration and low costs.

The battery management system 10 according to the embodiment of the present disclosure can detect the safety status of the power battery 20 with high efficiency, such that personal safety of a user can be effectively ensured, a risk of thermal runaway of the entire vehicle can be reduced, and property safety can be ensured.

An embodiment of the present disclosure further provides an electric vehicle. The electric vehicle includes the battery management system 10 according to any one of the foregoing embodiments.

The electric vehicle according to the embodiment of the present disclosure has beneficial technical effects substantially similar to those of the battery management system 10 described above, which will not be repeated herein.

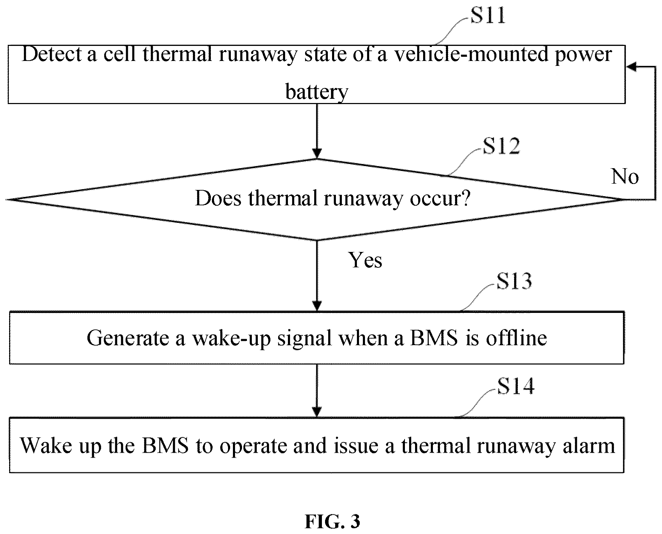

An embodiment of the present disclosure further provides a power battery protection method. FIG. 3 illustrates a flowchart of a power battery protection method according to an embodiment of the present disclosure. As shown in FIG. 3, the power battery protection method according to the embodiment of the present disclosure includes step S11 to step S14.

At step S11, a cell thermal runaway state of a vehicle-mounted power battery 20 is detected.

At step S12, it is determined whether thermal runaway occurs in a cell of the power battery 20. If yes, the method proceeds to step S13. Otherwise, the method returns to step S11 to continue the detection.

At step S13, when it is determined in step S12 that the thermal runaway occurs in the cell of the power battery 20, a wake-up signal is generated when a battery management system 10 is offline.

At step S14, the battery management system 10 is woken up via the wake-up signal generated in step S13 to operate and issue a thermal runaway alarm.

In some embodiments, the step S11 of detecting the cell thermal runaway state of the vehicle-mounted power battery 20 may include: collecting a cell voltage and/or a cell temperature of the power battery 20 online and/or offline at a predetermined sampling period; comparing the collected cell voltage of the power battery 20 with a predetermined voltage limit and/or comparing the collected cell temperature of the power battery 20 with a predetermined temperature limit; and determining that the thermal runaway occurs in the cell of the power battery 20 in response to the cell voltage of the power battery 20 exceeding the predetermined voltage limit and/or the cell temperature of the power battery 20 exceeding the predetermined temperature limit.

In some embodiments, the step S11 of detecting the cell thermal runaway state of the vehicle-mounted power battery 20 may include: collecting a current of the power battery 20; and determining that the thermal runaway occurs in the cell of the power battery 20 in response to the collected current of the power battery 20 exceeding a short-circuit protection current limit.

In some embodiments, the power battery protection method according to the present disclosure may further include: in response to the collected current of the power battery 20 exceeding an overcurrent protection current limit, generating an overcurrent hardware signal to the battery management system 10 to perform overcurrent protection on the power battery 20; and in response to the collected current of the power battery 20 exceeding the short-circuit protection current limit, generating a short-circuit hardware signal to the battery management system 10, such that the battery management system 10 controls a pyrofuse 30 connected in series in a load circuit to blow, where the load circuit includes the power battery 20 and a load 40 connected in series.

In some embodiments, the step S11 of detecting the cell thermal runaway state of the vehicle-mounted power battery 20 may include: detecting a pressure of the power battery 20 online and/or offline; comparing the detected pressure of the power battery 20 with a predetermined pressure limit; and determining that the thermal runaway occurs in the cell of the power battery 20 in response to the detected pressure of the power battery 20 exceeding the predetermined pressure limit.

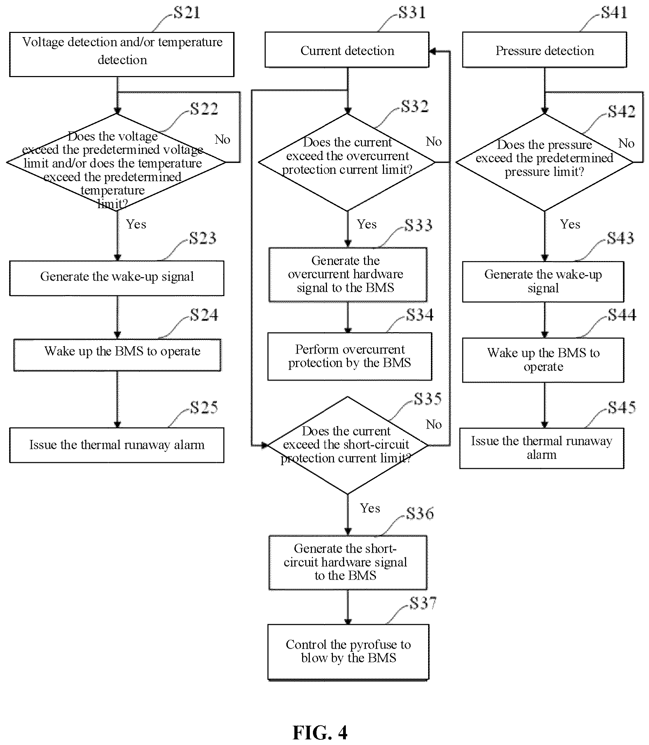

FIG. 4 illustrates specific steps of a power battery protection method according to an embodiment of the present disclosure. As shown in FIG. 4, at step S21, a cell voltage and/or a cell temperature of a power battery 20 may be detected online and/or offline at a predetermined sampling period. At step S22, it is determined whether the collected cell voltage of the power battery 20 exceeds a predetermined voltage limit, and/or whether the collected cell temperature of the power battery 20 exceeds a predetermined temperature limit. If yes, the method proceeds to step S23. Otherwise, the method returns to step S21. At step S23, when the cell voltage of the power battery 20 exceeds the predetermined voltage limit and/or the cell temperature of the power battery 20 exceeds the predetermined temperature limit, and when a BMS 10 is offline, a wake-up signal is generated. At step S24, the BMS 10 is woken up to operate via the wake-up signal. At step S25, the BMS 10 may issue a thermal runaway alarm.

At step S31, a current of the power battery 20 may be detected. At step S32, it is determined whether the collected current of the power battery 20 exceeds an overcurrent protection current limit. If yes, the method proceeds to step S33. Otherwise, the method returns to step S31. At step S33, when the current of the power battery 20 exceeds the overcurrent protection current limit, an overcurrent hardware signal is generated to the BMS 10. At step S34, the BMS 10 may perform overcurrent protection on the power battery 20. At step S35, the method continues to determine whether the collected current of the power battery 20 exceeds a short-circuit protection current limit. If yes, the method proceeds to step S36. Otherwise, the method returns to step S31. At step S36, when the current of the power battery 20 exceeds the short-circuit protection current limit, a short-circuit hardware signal is generated to the BMS 10. At step S37, the BMS 10 may control a pyrofuse 30 connected in series in a load circuit to blow quickly, so as to perform overcurrent protection on the power battery 20.

At step S41, the pressure of the power battery 20 may be detected online and/or offline. At step S42, it is determined whether the collected pressure of the power battery 20 exceeds a predetermined pressure limit. If yes, the method proceeds to step S43. Otherwise, the method returns to step S41. At step S43, a wake-up signal is generated when the pressure of the power battery 20 exceeds the predetermined pressure limit and the BMS 10 is offline. At step S44, the BMS 10 is woken up to operate via the wake-up signal. At step S45, the BMS 10 may issue a thermal runaway alarm.

The power battery protection method according to the embodiment of the present disclosure can provide good and multi-aspect safety protection functions for the power battery.

It should be noted that, in this specification, relational terms such as "first" and "second" are merely used to distinguish one entity or operation from another entity or operation, and do not necessarily require or imply that there is any such actual relationship or order between these entities or operations. The terms "include", "comprise" or any other variations thereof are intended to cover non-exclusive inclusion, so that a process, method, article or device that includes a series of elements includes not only those elements, but also other elements that are not explicitly listed, or elements inherent to such a process, method, article or device. An element defined by the phrase "including a..." does not, without more constraints, preclude the existence of additional identical elements in the process, method, article, or device that includes the element.

The battery management system, the electric vehicle, and the power battery protection method provided in the embodiments of the present disclosure have been described in detail above. Specific examples are used in this specification to describe principles and implementations of the present disclosure, and the descriptions of the foregoing embodiments are merely used to help understand the method and its core idea of the present disclosure, and content of this specification should not be understood as a limitation on the present disclosure. At the same time, for those of ordinary skill in the art, according to the idea of the present disclosure, any modification, equivalent replacement or improvement may be made on the specific implementation and application scope, which should be included in the scope of the claims of the present disclosure.

## Claims

1. A battery management system, comprising:
a detection board, connected to a vehicle-mounted power battery and configured for detecting a cell thermal runaway state of the power battery; and
a control board, connected to the detection board and comprising a power supply chip and a controller,
wherein the detection board is disposed independently of the control board, the detection board is connected to the power supply chip, and the power supply chip is connected to the controller.

2. The battery management system according to claim 1, wherein when the battery management system is offline, in response to detecting that thermal runaway occurs in a cell of the power battery, the detection board is further configured for generating a wake-up signal, and waking up the controller via the power supply chip to enable the battery management system to operate.

3. The battery management system according to claim 2, wherein when the thermal runaway occurs in the cell of the power battery, the controller is further configured for issuing a thermal runaway alarm.

4. The battery management system according to claim 2, wherein the detection board comprises a cell collection board, and the cell collection board is configured for collecting a cell voltage and/or a cell temperature of the power battery online and/or offline at a predetermined sampling period.

5. The battery management system according to claim 4, wherein
the cell collection board is configured for comparing the collected cell voltage of the power battery with a predetermined voltage limit and/or comparing the collected cell temperature of the power battery with a predetermined temperature limit; and when the battery management system is offline, in response to the cell voltage of the power battery exceeding the predetermined voltage limit and/or the cell temperature of the power battery exceeding the predetermined temperature limit, generating the wake-up signal.

6. The battery management system according to claim 2, wherein the detection board further comprises a high-voltage current collection board, and the high-voltage current collection board is configured for collecting a current of the power battery.

7. The battery management system according to claim 6, wherein the high-voltage current collection board is configured for obtaining the current of the power battery by collecting a voltage across a detection resistor connected in series in a load circuit, wherein the load circuit comprises the power battery and a load connected in series.

8. The battery management system according to claim 6, wherein in response to the collected current of the power battery exceeding an overcurrent protection current limit, the high-voltage current collection board is further configured for generating an overcurrent hardware signal to the controller, such that the controller is configured for performing overcurrent protection on the power battery.

9. The battery management system according to claim 6 or 8, wherein in response to the collected current of the power battery exceeding a short-circuit protection current limit, the high-voltage current collection board is further configured for generating a short-circuit hardware signal to the controller, such that the controller is configured for controlling a pyrofuse connected in series in a load circuit to blow.

10. The battery management system according to claim 1, wherein the control board further comprises a low-voltage uninterruptible power supply and a pressure detection module, the low-voltage uninterruptible power supply is configured for supplying power to the pressure detection module, the pressure detection module is connected to the power supply chip, and the pressure detection module is configured for detecting a pressure of the power battery online and/or offline.

11. The battery management system according to claim 10, wherein when the battery management system is offline, in response to the detected pressure of the power battery exceeding a predetermined pressure limit, the pressure detection module is further configured for generating a wake-up signal, and waking up the controller via the power supply chip to enable the battery management system to operate.

12. An electric vehicle, comprising the battery management system according to any one of claims 1 to 11.

13. A power battery protection method, comprising:
detecting a cell thermal runaway state of a vehicle-mounted power battery;
generating a wake-up signal in response to detecting that thermal runaway occurs in a cell of the power battery when a battery management system is offline; and
waking up the battery management system to operate via the wake-up signal and issuing a thermal runaway alarm.

14. The method according to claim 13, wherein detecting the cell thermal runaway state of the vehicle-mounted power battery comprises:
collecting a cell voltage and/or a cell temperature of the power battery online and/or offline at a predetermined sampling period;
comparing the collected cell voltage of the power battery with a predetermined voltage limit and/or comparing the collected cell temperature of the power battery with a predetermined temperature limit; and
in response to the cell voltage of the power battery exceeding the predetermined voltage limit and/or the cell temperature of the power battery exceeding the predetermined temperature limit, determining that the thermal runaway occurs in the cell of the power battery.

15. The method according to claim 13, wherein detecting the cell thermal runaway state of the vehicle-mounted power battery comprises:
collecting a current of the power battery; and
determining that the thermal runaway occurs in the cell of the power battery in response to the collected current of the power battery exceeding a short-circuit protection current limit.

16. The method of claim 15, further comprising:
in response to the collected current of the power battery exceeding an overcurrent protection current limit, generating an overcurrent hardware signal to the battery management system to perform overcurrent protection on the power battery; and
in response to the collected current of the power battery exceeding the short-circuit protection current limit, generating a short-circuit hardware signal to the battery management system, such that the battery management system controls a pyrofuse connected in series in a load circuit to blow, wherein the load circuit comprises the power battery and a load connected in series.

17. The method according to claim 13, wherein detecting the cell thermal runaway state of the vehicle-mounted power battery comprises:
detecting a pressure of the power battery online and/or offline;
comparing the detected pressure of the power battery with a predetermined pressure limit; and
determining that the thermal runaway occurs in the cell of the power battery in response to the pressure of the power battery exceeding the predetermined pressure limit.
